# EUROPÄISCHE PATENTSCHRIFT

(11) **EP 1 811 822 B1**
(45) Veröffentlichungstag und Bekanntmachung des Hinweises auf die Patenterteilung: **13.06.2012**
(21) Anmeldenummer: 07001174.7
(22) Anmeldetag: 19.01.2007
(51) Int. Cl.: H05K 3/34

(54) **Lötbauteilanordnung**
Solder component assembly
Agencement de composant de brasage

(30) Priorität: 19.01.2006 DE 102006002729
(43) Veröffentlichungstag der Anmeldung: 25.07.2007
(73) Patentinhaber: Amphenol-Tuchel Electronics GmbH, 74080 Heilbronn (DE)
(72) Erfinder: Dörr, Martin, 74078 Heilbronn (DE); Niedenzu, Volker, 74172 Neckarsulm (DE); Kuntz, Julio, 74861 Neudenau (DE)
(74) Vertreter: Carstens, Dirk Wilhelm

(56) Entgegenhaltungen:
- DE-A1- 4 405 578
- JP-A- 8 213 270

## Beschreibung

Die Erfindung bezieht sich auf eine Lötbauteilanordnung, bei der ein Lötbauteil, welches einseitig mit einem oder mehreren Kontaktelementen ausgestattet ist, an einer Leiterplatte angelötet ist.

Wenn Kontaktelemente nur einseitig, also auf der Lötseite, an einem Isolierkörper eines Lötbauteils angebracht sind, so kann beim Anlöten eines solchen Lötbauteils z. B. an einer Leiterplatte der sogenannte Tombstone-Effekt auftreten, d.h. das Lötbauteil hebt sich von der Leiterplatte von der Seite ab, die entgegengesetzt zur Lötseite liegt.

Ein solches Lötbauteil ist aus Dokument JP 08213270 bekannt.

Üblicherweise wird dies dadurch vermieden, dass entgegengesetzt zur Lötseite Befestigungsmittel für den Isolierkörper vorgesehen werden. Alternativ werden die Kontaktelemente am Isolierkörper so verteilt angeordnet, dass der Tombstone-Effekt nicht auftreten kann. Dies schließt aber eine einseitige Anordnung der Kontaktelemente, die oftmals erwünscht ist, aus. Die vorliegende Erfindung sieht eine Lötbauteilanordnung vor, bei der ein Lötbauteil, welches einseitig mit einem oder mehreren Kontaktelementen ausgestattet ist, trotz dieser einseitigen Anordnung den Tombstone-Effekt vermeidet.

Erfindungsgemäß wird das Kontaktelement bzw. die Kontaktelemente derart ausgebildet und in dem Isolierkörper angeordnet, dass die von den Kontaktelementen gebildeten Lötflächen zum Anlöten an den Lötpads der Leiterplatte schräg gegenüber den Lötflächen der Lötpads verlaufen, so dass ein abgewinkelter Spalt zwischen den Lötflächen des Kontaktelements und des Lötpads für die Aufnahme des Lots entsteht. Diese Verfahrensweise ist günstiger, als etwa die Möglichkeit, die Lötfläche der Lötpads anzuschrägen.

Erfindungsgemäß ist eine Aussparung vorgesehen, die eine Benetzungslinie unterbricht und die Lötspannungen minimiert und zwar vorzugsweise mit dem leicht nach oben hin geneigten Verlauf einer im Kontaktelement vorgesehenen Lötfläche.

Dadurch das der die Kontaktelemente tragende Isolierkörper mit einer gewünschten Höhe ausgebildet werden kann, ist es möglich, mittels der erfindungsgemäßen Lötbauteilanordnung praktisch die Anschlusspads der Leiterplatte auf eine größere Höhe "heraufzutransformieren". Zu diesem Zweck bilden dann die Kontaktelemente an der Oberseite des Isolierkörpers den Lötpads entsprechende Kontaktflächen.

Weitere Vorteile, Ziele und Einzelheiten der Erfindung ergeben sich aus der Beschreibung eines Ausführungsbeispiels anhand der Zeichnung; in der Zeichnung zeigt:
- Fig. 1: eine Draufsicht auf eine Leiterplatte, die verschiedene Lötflächen bzw. Kontaktflächen bildende Kontaktpads, aufweist;
- Fig. 2: eine Vergrößerung eines Teils der Fig. 1;
- Fig. 3: einen vergrößerten Schnitt durch eine erfindungsgemäße Lötbau- teilanordnung bestehend aus einem Lötbauteil, das an einer Lei- terplatte erfindungsgemäß angelötet ist;
- Fig.4: eine perspektivische vergrößerte Ansicht des Lötbauteils von unten;
- Fig. 5: eine perspektivische Ansicht des Lötbauteils von oben;
- Fig. 6: eine Seitenansicht der erfindungsgemäßen Lötbauteilanordnung, bei der Tombstone-Effekt nicht eintritt;
- Fig.7: eine Seitenansicht einer Lötbauteilanordnung bei der der Tombstone-Effekt eingetreten ist;
- Fig. 8: ein Schnitt ähnlich wie Fig. 3 ohne, dass das Lot zugeführt wur- de; und
- Fig. 9: ein Schnitt durch das in Fig. 8 dargestellte Kontaktelement.

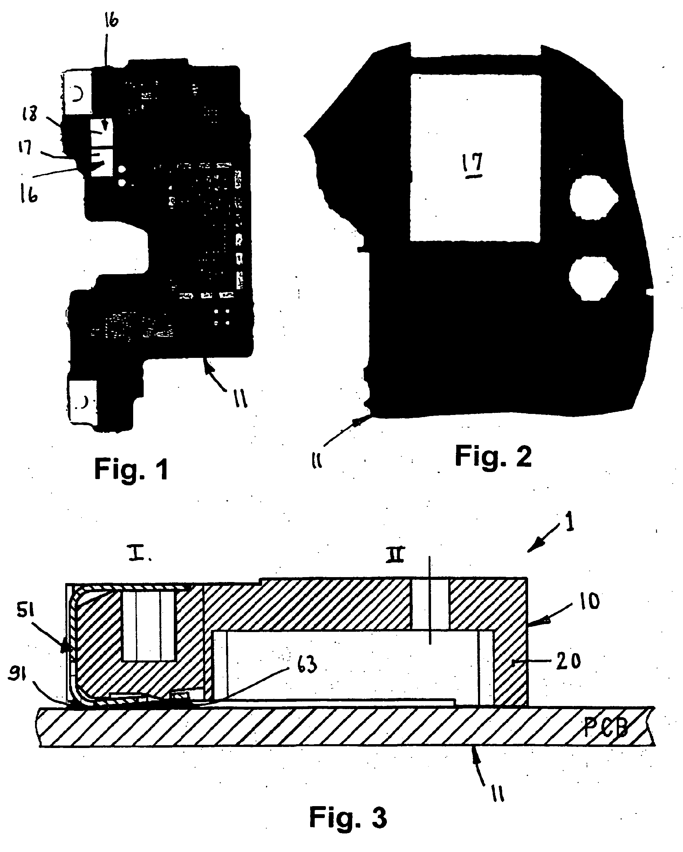

Fig. 1 zeigt die etwa 3-fach vergrößerte Draufsicht auf eine Leiterplatte 11 auf der zwei benachbart angeordnete Kontaktpads 16 gezeigt sind, die jeweils eine Kontaktfläche bzw. Lötflächen 17 und 18 besitzen.

In Fig. 2 ist eine Ausschnittsvergrößerung der in Fig. 1 gezeigten Leiterplatte 11, und zwar insbesondere der Lötfläche 17.

In Fig. 3 ist eine Lötbauteilanordnung 1 dargestellt, die aus der Leiterplatte 11 gemäß den Figuren 1 und 2 und einem Lötbauteil 10 gebildet wird. Das Lötbauteil 10 besitzt einen Isolierkörper 20, der im Bereich einer Anschlussseite I von einem Kontaktelement 51 umfasst wird, welches mittels eines Lots 63 an der Lötfläche (z.B. 17) des Kontaktpads (z.B. 16) der Leiterplatte 11 angelötet ist. Die in Fig. 2 gezeigte Lötfläche 17 muss man sich unterhalb des Lots 63 in Fig. 3 liegend vorstellen.

In Fig. 3 ist mit II eine der Anschlussseite I gegenüberliegende oder von dieser beabstandete Seite des Lötbauteils 10 bezeichnet.

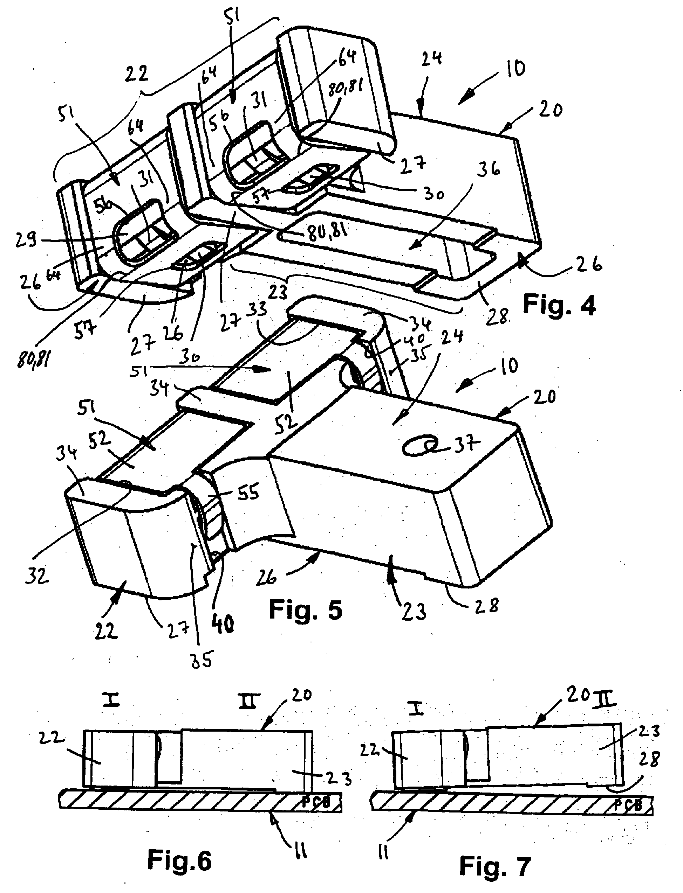

Die Figuren 4 und 5 zeigen das Lötbauteil 10 ohne die Leiterplatte 11. Das Lötbauteil 10 besteht aus dem bereits erwähnten Isolierkörper 20 sowie z.B. zwei daran befestigten Kontaktelementen 51. Der Isolierkörper 20 bildet eine Oberseite 24 sowie eine Unterseite 26 mit beabstandeten Auflageflächen 27 und 28. Der Isolierkörper 20 bildet ferner am Übergang zwischen seiner Rückseite 29 (Fig. 4) und seiner Unterseite 26 Rastnasen 31, sowie an seiner Unterseite 26 Rastnasen 30. An der Oberseite 24 des Isolierkörpers 20 sind im Bereich eines Kontaktträgerteils 22 des Isolierkörpers 20 benachbarte Ausschnitte 32 und 33 vorgesehen, die durch Stege 34 begrenzt werden. Ferner bildet der Isolierkörper 20 einen senkrecht vom Kontaktträgerteil 22 wegverlaufenden Nasenteil 23 der einen Hohlraum 36 besitzt, der von der Oberseite 24 her durch ein Loch 37 erreicht wird. An den quer zum Nasenteil 23 verlaufenden Vorderseiten 35 des Kontaktträgerteils 22 sind Eingriffsnuten 40 zu beiden Seiten des Nasenteils 23 gebildet.

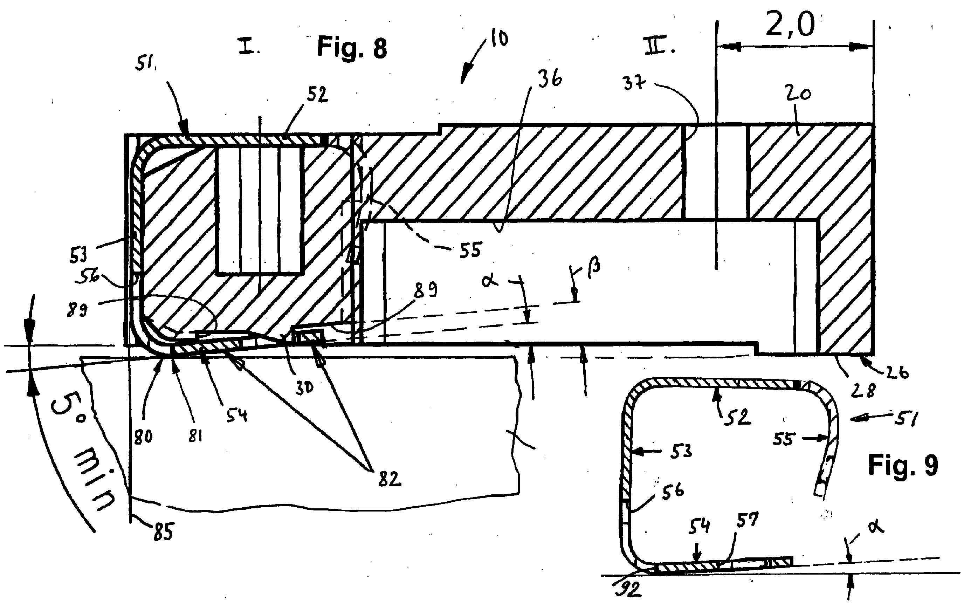

Jedes der Kontaktelemente 51 weist - vergleiche dazu auch Fig. 8 und 9 - folgendes auf: einen Oberteil bzw. Kontaktteil 52, einen Hinterteil oder Halteteil 53, einen Unterteil bzw. Lötteil 54 sowie einen Vorderteil bzw. Haltearm 55.

Ferner ist erfindungsgemäß eine Ausnehmung oder Öffnung 56 im Übergangsbereich vom Hinterteil 53 zum Unterteil 54 vorgesehen, die auch zur Zusammenarbeit mit Nase 31 dient aber vor allem zur Beseitigung des Tombstone Effekts. Im Unterteil 54 ist ferner eine Rastöffnung 57 ausgebildet, die mit der Rastnase 30 des Isolierkörpers 20 zusammenarbeitet. Die Ausnehmung 56 endet mit ihrer unteren Längskante 92 - vgl. Fig. 9 - an einer noch zu beschreibenden Benetzungslinie 81 (Fig. 8).

Die Figuren 6 und 7 veranschaulichen den sogenannten Tombstone-Effekt, der bei der Darstellung der Fig. 6 wegen der erfindungsgemäßen Maßnahmen nicht auftritt, während er ohne Verwendung der erfindungsgemäßen Maßnahmen, gemäß Fig. 7, auftritt, da wegen der einseitigen Positionierung der Kontaktelemente 51 im Kontaktträgerteil 22, die der Lötseite 1 gegenüberliegende Seite II des Isolierkörpers 20 (also der Nasenteil 23) die Tendenz hat, sich von der Leiterplatte 11 wegzubewegen.

Die Figuren 8 und 9 veranschaulichen weitere wichtige Merkmale der vorliegenden Erfindung im Einzelnen. Erfindungsgemäß ist der Unterteil bzw. Lötteil 54 des Kontaktelements 51 gegenüber der Lötfläche 17 des Lötpads 16 nach oben (vgl. Fig. 8) vorzugsweise um einen kleinen Winkel von beispielsweise 5 Grad minimal abgewinkelt. Auf diese Weise verläuft bei der dargestellten Anordnung auch eine Lötfläche 82, die von dem Unterteil 54 gebildet wird, unter dem Winkel α nach oben.

Am Übergang zwischen dem Hinterteil 53 und dem Unterteil 54 wird eine in Fig. 8 mit 80 bezeichnete Auflagelinie oder der Auflagepunkt gebildet. Diese Auflagelinie 80 ist vorzugsweise wie in Fig. 4 gezeigt durch die Ausnehmung 56 unterteilt und steht in Metallkontakt mit dem Metall der Kontaktfläche 17 des Kontaktpads 16. Die Ausnehmung 56 unterteilt ferner auch eine erste Benetzungslinie 85, die von der Auflagelinie 80 zum Hinterteil 53 hin beabstandet ist. Benachbart zum Auflagepunkt bzw. der Auflagelinie 80 ist die Position einer zweiten (bereits erwähnten) Benetzungslinie mit 81 bezeichnet. D.h. die Benetzung durch Lot erfolgt bis zur zweiten Benetzungslinie 81 bzw. dem Benetzungspunkt 81 bei der erfindungsgemäßen Ausbildung der Lötfläche 82 und bis zu der ersten Benetzungslinie 85 am Hinterteil 53. Die erste Benetzungslinie 85 wird durch die Ausnehmung 56 im Bereich des Hinterteils 53 unterbrochen, so dass das Lot nur in den Bereichen von vier verbleibenden Stegen 64 des Hinterteils 53 bis zur ersten Benetzungslinie 85 an dem Kontaktelement 51 angreifen kann, wodurch die Lötspannungen entsprechend der Größe der Aussparung 56 minimiert werden und so dem Tombstone Effekt entgegengewirkt bzw. dieser verhindert wird. In den Bereichen der Ausnehmungen 56 verläuft die zweite durch die Ausnehmungen 56 verlegte Benetzungslinie 81 entlang bzw. nahe bei der Auflagelinie 80, so dass der Verlauf der Benetzungslinie 81 und die dort auftretenden Lötspannungen nicht zum Anheben des Lötbauteils 10 durch eben diese Lötspannungen führen. Der Auflagepunkt bzw. diese Auflagelinie 80 liegt auf einer Höhe wie die Auflagefläche 26.

Wie in Fig. 8 dargestellt ist, besitzt die Unterseite 26 des Isolierkörpers 20 eine Ausnehmung 89 mit der Rastnase 30 zur Aufnahme des freien Endes des Unterteils 54 des Kontaktelementes 51. Der Schrägverlauf (vgl. Fig. 8) der nach oben und zum Hohlraum 36 hin gerichteten Ausnehmung 89 ist mit dem Winkel β bezeichnet, der etwa die gleiche Größe besitzt, wie der Winkel α.

Das Lötbauteil 10 wurde anhand der Figuren 3 bis 8 als ein Bauteil beschrieben, welches bei Anordnung auf einer Leiterplatte 11 eine "Herauftransformation" der Leiterplattenpads 16 gemäß Fig. 1 ermöglicht. Dadurch kann ein Bauteil sozusagen indirekt auf der Leiterplatte 11 angebracht werden, welches sonst in Folge seiner Größe oder seiner Form andere auf der Leiterplatte 11 vorhandene Bauelemente stören würde, wenn die Anordnung ohne das Lötbauteil 10 erfolgen sollte.

Entscheidend für die Erfindung ist die Aussparung 56, die die Benetzungslinie 85 unterbricht und die Lötspannungen minimiert und der leicht nach oben hin geneigte Verlauf der am Kontaktelement 51 vorgesehenen Lötfläche 82, wobei diese Lötfläche 82 vorzugsweise durch ein Metallblechelement - wie gezeigt - gebildet wird, welches auf dem aus Isoliermaterial bestehenden Isolierkörper 20 befestigt wird, beispielsweise durch verrasten.

Wie erwähnt kann das Kontaktelement 51 mit der Ausnehmung 56 und der Rastöffnung 57 am Isolierkörper 20 verrastet werden, und Haltearme 55 der Kontaktelemente 51 werden vorzugsweise in Eingriffsnuten 40 an der Vorderseite des Kontaktträgerteils 22 eingepresst.

## Patentansprüche

1. Lötbauteil (10) mit einem Isolierkörper (20) und einem Kontaktelement (51) befestigt am Isolierkörper (20),
wobei das Kontaktelement (51) einen Lötteil (54) zum Anlöten vorzugsweise an einer Lötfläche (17) eines Kontaktpads (16) einer Leiterplatte (11) aufweist sowie einen Kontaktteil (52) zur weiteren Verbindung mit einem weiteren elektrischen Bauteil,
wobei der Lötteil (54) eine Lötfläche (82) besitzt, die einseitig am Isolierkörper (20) angeordnet ist, was beim Anlöten der Lötfläche (82) an eine Lötfläche (17) der Leiterplatte (11) zu einem sogenannten Tombstone-Effekt führen kann, d.h. ein Teil des Isolierkörpers (22) verschwenkt sich von der Leiterplatte (4) weg, wobei die Schwenkachse im Bereich der Anlötung liegt,
**dadurch gekennzeichnet, dass**
die Lötfläche (82) des Lötteils (54) unter einem Winkel α gegenüber der Oberfläche der Lötfläche (17) der Leiterplatte (11) verlaufend ausgebildet ist.

2. Lötbauteil nach Anspruch 1, **dadurch gekennzeichnet, dass** der Winkel
α klein, beispielsweise in der Größenordung bei etwa 5° liegt.

3. Lötbauteil nach einem der vorhergehenden Ansprüche, **dadurch gekennzeichnet, dass** im Bereich einer ersten Benetzungslinie (85) des Kontaktelements (51) dieses eine Ausnehmung (56) aufweist, die die erste Benetzungslinie (85) unterbricht und dass die Ausnehmung (56) mit ihrer unteren Längskante (92) eine zweite Benetzungslinie (81) bildet.

4. Lötbauteil nach Anspruch 3, dass die untere Längskante (92) der Ausnehmung (56) benachbart und vorzugsweise in etwa parallel zu einer Auflagelinie (80) des Kontaktteils (52) verläuft.

5. Lötbauteil nach einem der vorhergehenden Ansprüche, **dadurch gekennzeichnet, dass** der Lötteil (54) mit seiner Unterseite den Auflagepunkt bzw. die Auflagelinie (80) definiert, die bzw. der mit der Lötfläche (17) in Metallberührung steht.

6. Lötbauteil nach Anspruch 4, **dadurch gekennzeichnet, dass** benachbart zum Auflagelinie (80) die Benetzungslinie (81) gebildet wird, bis zu der hin, Lot in einen, zwischen der Kontaktfläche (17) und der Lötfläche (82) gebildeten Zwischenraum, einfließt.

7. Lötbauteil nach einem der vorhergehenden Ansprüche, **dadurch gekennzeichnet, dass** der Lötteil (54) an seiner Unterseite eine Rastöffnung (57) definiert.

8. Lötbauteil nach Anspruch 3, **dadurch gekennzeichnet, dass** das Kontaktelement (51) den Lötteil (54) als Unterteil (54) aufweist, der über ein Hinterteil (53) mit einem Oberteil oder Kontaktteil (52) einstückig ausgebildet ist.

9. Lötbauteil nach Anspruch 8 , **dadurch gekennzeichnet, dass** vom Oberteil (52) ein Vorderteil in Form eines Haltearms (55) vorgesehen ist

10. Lötbauteil nach Anspruch 8, **dadurch gekennzeichnet, dass** das die Ausnehmung (56) im Bereich des Übergangs vom Hinterteil (53) zum Unterteil (54) auch als eine Rastöffnung (56) dient.

11. Lötbauteil nach einem der vorhergehenden Ansprüche, **dadurch gekennzeichnet, dass** der Isolierkörper (20) einen Kontaktträgerteil (22) und einen Nasenteil (23) aufweist, die sich im wesentlichen senkrecht zueinander erstrecken, wobei benachbart zueinander zwei Kontaktelemente (51) einseitig bezüglich des Isolierkörpers (20) angeordnet sind.

12. Lötbauteil nach Anspruch 8, **dadurch gekennzeichnet, dass** das die Oberteile (52) der Kontaktelemente (51) Kontaktflächen (52) bilden, die den Kontaktflächen (16, 18) der Leiterplatte (11) entsprechen, aber auf einer Höhe oberhalb der Oberfläche der Leiterplatte (11) angeordnet sind, entsprechend der Höhe oder Dicke des Isolierkörpers (20).

13. Lötbauteil nach einem der vorhergehenden Ansprüche, **dadurch gekennzeichnet, dass** die Kontaktelemente (51) mit Ausnehmungen (56, 57) am Isolierkörper (20) verrastet werden, und dass Haltearme (55) der Kontaktelemente vorzugsweise in Eingriffsnuten (40) an der Vorderseite des Kontaktträgers (22) eingepresst werden.

14. Lötbauteil nach einem der vorhergehenden Ansprüche, **dadurch gekennzeichnet, dass** der Isolierkörper (20) Auflageflächen (27, 28) bildet, gegenüber welchen die Lötflächen (82) abgewinkelt nach oben verlaufen.

15. Lötbauteil nach Anspruch 3, **dadurch gekennzeichnet, dass** der Isolierkörper (20) Rastnasen (30, 31) zur Verrastung mit den Ausnehmungen bzw. Öffnungen (57, 56) bildet.

16. Lötbauteil nach einem oder mehreren der vorhergehenden Ansprüche, mit auf nur einer Seite des Lötbauteils angeordneten Kontaktelementen zum Anlöten an einer oder mehreren Kontaktflächen einer Leiterplatte, **dadurch gekennzeichnet, dass** das Kontaktelement oder die Kontaktelemente gegenüber der Lötfläche der Kontaktpads der Leiterplatte schräg weg verlaufende Lötflächen besitzen und dass mehrere Kontaktelemente (51) benachbart im Kontaktträgerteil (22) einseitig im Isolierkörper (20) angeordnet sind.

## Claims

1. A soldering component (10) comprising an insulator body (20) and a contact element (51) mounted to said insulator body (20),
wherein said contact element (51) comprises a solder portion (54) adapted to be preferably soldered to a soldering surface (17) of a contact pad (16) of a circuit board (11), said contact element (51) further comprising a contact portion (52) for the further connection with a further electric component,
wherein said solder portion (54) comprises a solder surface (82) located at one side of the insulating body (20), whereby when soldering the solder surface (82) to a solder surface (17) of the circuit board (11) a so-called Tombstone-effect can be created, i.e. a portion of the insulating body (22) pivots away from the circuit board (4), whereby the pivot axis is in the area of the soldering,
**characterized in that**
the solder surface (82) of the solder portion (54) extends under an angle α with respect to the surface of the soldering surface (17) of the circuit board (11).

2. A soldering component according to claim 1, **characterized in that** the angle α is small, for instance in the order of 5 degrees.

3. A soldering component of one of the preceding claims, **characterized in that** the contact element (51) comprises a recess (56) in the area of a first wetting line (85) of the contact element,
said recess (56) interrupting said first wetting line (85) and wherein said recess (56) forms with its lower longitudinal edge (92) a second wetting line (81).

4. A soldering component according to claim 3, wherein the lower longitudinal edge (92) of the recess (56) is adjacent and preferably in substance parallel to an abutment line (80) of the contact portion (52).

5. A soldering component according to one of the preceding claims, **characterized in that** the soldering portion (54) defines with its bottom side an abutment point and the abutment line (80), respectively, being in metal contact with the soldering surface (17).

6. A soldering component according to claim 4, **characterized in that** adjacent to the abutment line (80) the wetting line (81) is formed up to which the solder flows in between the inter space formed between the contact surface (17) and the solder surface (82).

7. A soldering component as set forth in one of the preceding claims, **characterized in that** the solder portion (54) defines at its bottom side a detent opening (57).

8. A soldering component according to claim 3, **characterized in that** the contact element (51) comprises the soldering portion (54) as a bottom portion (54), said bottom portion being formed via a back portion (53) with an upper portion or contact portion (52) as a single piece.

9. A soldering component according to claim 8, **characterized in that** the upper portion (52) comprises a front portion in the form of a holding arm (55).

10. A soldering component according to claim 8, **characterized in that** the recess (56) which is in the area of the transform from the back portion (53) to the bottom portion (54) also serves as a detent opening (56).

11. A soldering component according to one of the preceding claims, **characterized in that** the insulating body (20) comprises a contact support portion (22) and a nose portion (23) which extend in substance perpendicularly with respect to each other, wherein two contact elements (51) are arranged adjacent to each other on the one side with respect to the insulating body (20).

12. A soldering component according to claim 8, **characterized in that** the upper portions (52) of the contact elements (51) form contact surfaces (52) which correspond to the contact surfaces (16, 18) of the circuit board (11), are arranged on a level above the upper surface of the circuit board (11) in correspondence with the height or thickness of the insulating body (20).

13. A soldering component according to one of the preceding claims, **characterized in that** the contact elements (51) are engaged with recesses (56, 57) at the insulating body (20) and further, holding arms (55) of the contact elements are preferably pressed into engagement grooves (40) at the front side of the contact support (22).

14. A soldering component according to one of the preceding claims, **characterized in that** the insulating body (20) forms abutment surfaces (27, 28) opposite to which the soldering surfaces (82) are angled upwardly.

15. A soldering component according to claim 3, **characterized in that** insulating body (20) forms detent noses (30, 31) for engagement with the recesses and openings (57, 56), respectively.

16. A soldering component according to one or more of the preceding claims with contact elements being arranged only on one side of the soldering component, said contact elements being adapted to be soldered to one or more of the contact surfaces of a circuit board, **characterized in that** the contact element or the contact elements are provided with soldering surfaces which, with respect to the soldering surface of the contact pads of the circuit board comprise inclined soldering surfaces and wherein further a plurality of contact elements (51) is arranged adjacent to the contact support portion (22) on one side in the insulating body (20).

## Revendications

1. Composant de soudure (10) comprenant un corps isolant (20) et un élément de contact (51) monté sur le corps isolant (20),
dans lequel l'élément de contact (51) comprend une partie à souder (54) adaptée à être de préférence soudée à une surface de soudure (17) d'un plot de contact (16) d'une carte de circuit (11), l'élément de contact (51) comprenant en outre une partie de contact (52) pour une connexion supplémentaire à un autre composant électrique,
dans lequel la partie à souder (54) comprend une surface de soudure (82) située d'un côté du corps isolant (20), d'où il résulte lorsqu'on soude la surface de soudure (82) à une surface de soudure (17) de la carte de circuit (11) un effet dit de Tombstone peut est créé, c'est-à-dire qu'une partie du corps isolant (22) pivote en s'éloignant de la carte de circuit (4), l'axe de pivotement étant dans la zone de soudure,
**caractérisé en ce que**
la surface de soudure (82) de la partie à souder (54) s'étend avec un angle α par rapport à la surface de soudure (17) de la carte de circuit (11).

2. Composant de soudure selon la revendication 1, **caractérisé en ce que** l'angle α est petit, par exemple de l'ordre de 5 degrés.

3. Composant de soudure selon l'une quelconque des revendications précédentes, **caractérisé en ce que** l'élément de contact (51) comprend un renfoncement (56) dans la zone d'une première ligne de mouillage (85) de l'élément de contact,
le renfoncement (56) interrompant la première ligne de mouillage (85) et le renfoncement (56) formant, avec son bord longitudinal inférieur (92), une deuxième ligne de mouillage (81).

4. Composant de soudure selon la revendication 3, dans lequel le bord longitudinal inférieur (92) du renfoncement (56) est adjacent et de préférence sensiblement parallèle à une ligne de butée (80) de la partie de contact (52).

5. Composant de soudure selon l'une quelconque des revendications précédentes, **caractérisé en ce que** la partie à souder (54) définit avec son côté inférieur un point de butée et la ligne de butée (80), respectivement, est en contact métallique avec la surface de soudure (17).

6. Composant de soudure selon la revendication 4, **caractérisé en ce que**, à côté de la ligne de butée (80), la ligne de mouillage (81) est formée jusqu'où coule la soudure dans l'intervalle formé entre la surface de contact (17) et la surface de soudure (82).

7. Composant de soudure selon l'une quelconque des revendications précédentes, **caractérisé en ce que** la partie à souder (54) définit au niveau de son côté inférieur une ouverture de détente (57).

8. Composant de soudure selon la revendication 3, **caractérisé en ce que** l'élément de contact (51) comprend la partie à souder (54) en tant que partie inférieure (54), la partie inférieure étant formée par l'intermédiaire d'une partie arrière (53) avec une partie supérieure ou partie de contact (52) d'une seule pièce.

9. Composant de soudure selon la revendication 8, **caractérisé en ce que** la partie supérieure (52) comprend une partie avant ayant la forme d'une patte de maintien (55).

10. Composant de soudure selon la revendication 8, **caractérisé en ce que** le renfoncement (56) qui est dans la zone de transformation entre la partie arrière (53) et la partie inférieure (54) sert aussi d'ouverture de détente (56).

11. Composant de soudure selon l'une quelconque des
revendications précédentes, **caractérisé en ce que** le corps isolant (20) comprend une partie de support de contact (22) et une partie de nez (23) qui sont sensiblement perpendiculairement entre elles, deux éléments de contact (51) étant disposés côte à côte sur le même côté du corps isolant (20).

12. Composant de soudure selon la revendication 8, **caractérisé en ce que** les parties supérieures (52) des éléments de contact (51) forment des surfaces de contact (52) qui correspondent aux surfaces de contact (16, 18) de la carte de circuit (11), et sont disposées sur un niveau au-dessus de la surface supérieure de la carte de circuit (11) en correspondance avec la hauteur ou l'épaisseur du corps isolant (20).

13. Composant de soudure selon l'une quelconque des revendications précédentes, **caractérisé en ce que** les éléments de contact (51) sont en contact avec des renfoncements (56, 57) dans le corps isolant (20) et en outre, des pattes de maintien (55) des éléments de contact sont de préférence pressées dans des gorges d'engagement (40) au niveau du côté avant du support de contact (22).

14. Composant de soudure selon l'une quelconque des revendications précédentes, **caractérisé en ce que** le corps isolant (20) forme des surfaces de butée (27, 28) opposées avec lesquelles les surfaces de soudure (82) font un angle vers le haut.

15. Composant de soudure selon la revendication 3, **caractérisé en ce que** le corps isolant (20) forme des ergots de verrouillage (30, 31) s'engageant dans les renfoncements et les ouvertures (57, 56), respectivement.

16. Composant de soudure selon l'une quelconque des revendications précédentes, dans lequel des éléments de contact sont disposés seulement d'un côté du composant de soudure, les éléments de contact étant adaptés à être soudés à une ou plusieurs des surfaces de contact d'une carte de circuit, **caractérisé en ce que** l'élément de contact ou les éléments de contact sont munis de surfaces de soudure qui, en ce qui concerne la surface de soudure des plots de contact de la carte de circuit, comprennent des surface inclinées, et dans lequel en outre une pluralité d'éléments de contact (51) est disposée à côté de la partie de support de contact (22) d'un côté du corps isolant (20).
